# EUROPEAN PATENT SPECIFICATION

(11) **EP 2 930 523 B1**
(45) Date of publication and mention of the grant of the patent: **16.11.2016**
(21) Application number: 14164128.2
(22) Date of filing: 10.04.2014
(51) Int. Cl.: G01R 31/28, G01R 31/302

(54) **Contactless conductive interconnect testing**
Kontaktlose Prüfung einer leitfähigen Verbindung
Test d'interconnexion conductrice sans contact

(43) Date of publication of application: 14.10.2015
(73) Proprietor: D-CON AB, 941 63 PITEÅ (SE)
(72) Inventor: Delsing, Jerker, 941 63 PITEÅ (SE); Abdelghani, Renbi, 954 34 GAMMELSTAD (SE)
(74) Representative: Awapatent AB

(56) References cited:
- US-A- 5 218 294
- US-A1- 2004 150 409
- US-A1- 2005 017 743
- US-A1- 2005 242 824

## Description

### TECHNICAL FIELD

The present disclosure relates to a device and a method for contactless testing of a conductive interconnect on a circuit board, the term "contactless" meaning that direct electrical contact with the conductive interconnect under test is not required.

### BACKGROUND

The electronic circuits inside a piece of electrical equipment are typically provided in the form of electronic components on circuit boards, such as printed circuit boards and printed wiring boards. The production of such circuits often includes inspection for manufacturing defects. Examples of typical defects are short circuits, open circuits and misplaced components, and ensuring that the electronic circuit is likely to have been manufactured correctly usually involves measuring resistance, capacitance or inductance between two points in the circuit.

Electronic circuits are becoming smaller and more dense as the overall miniaturization of electronic devices continues, driven by factors such as a demand for greater portability, reduced costs and higher technical performance. The reduction in size creates a challenge for testing circuits for manufacturing defects, in particular when using testing devices that require electrical contact with the circuits through probes or the like.

When testing a dense circuit for manufacturing defects, contactless testing clearly offers certain advantages vis-à-vis methods necessitating electrical contact with the conductive interconnect under test. An example of a contactless test method and apparatus is disclosed in US 5517110. According to this disclosure, manufacturing defects are found through the analysis of a displacement current obtained by providing a relative movement between the circuit board and an electromagnetic field generated by one or more stimulators.

Further examples of test methods and apparatuses are disclosed in the following documents: US 2004/150409 A1 is directed to the inspection of circuit boards having combed-shaped conductive patterns, US 5218294 A discloses a method for testing unpopulated circuit boards, US 2005/242824 A1 relates to the testing of electrical paths through connectors on circuit assemblies, and US 2005/0017743 A1 is directed to detecting or diagnosing a failure state of an electronic circuit.

A contactless testing device should preferably have a simple construction and be able to provide precise information about possible manufacturing defects of the circuit under test. It is possible to improve existing contactless testing devices in these respects.

### SUMMARY

The objective is to provide an improved or alternative contactless testing device for interconnects on a circuit board, such as a printed circuit board or a printed wiring board. Aspects of particular interest include the ability of the testing device to provide reliable measurements and its simplicity of design and use.

The invention is defined by the independent claims. Embodiments are set forth in the dependent claims, the description and the drawings.

According to a first aspect, there is provided a testing device for contactless testing of a conductive interconnect on a circuit board, in particular a printed circuit board or a printed wiring board. The testing device comprises a testing circuit having a conductive sensing path electrically connected between a first terminal and a second terminal, the extension of the conductive sensing path corresponding to the extension of the conductive interconnect. The testing device also comprises a signal generator and a processing circuitry. The signal generator is configured to generate an input signal to be transmitted from the first terminal to the second terminal via the conductive sensing path. The processing circuitry is configured to receive an output signal at the second terminal and to determine a property of the conductive interconnect based on the output signal when the conductive sensing path is parallel displaced relative to the conductive interconnect, along a direction perpendicular to a parallel plane to the conductive interconnect, and when the conductive sensing path forms a galvanically isolated connection with the conductive interconnect.

By "the extension of the conductive sensing path corresponding to the extension of the conductive interconnect" is meant that the shapes of the extensions are identical or similar. For example, if the conductive interconnect is straight and has a certain length then the conductive sensing path can be straight and have the same length, or approximately the same length. If the conductive interconnect is curved then the conductive sensing path can be identically curved, or similarly curved. The shape of the extension of the conductive sensing path can, however, be simpler than that of conductive interconnect. For instance, if the conductive interconnect is a parallel bus then the conductive sensing path can be a coil, such as a meander coil, something which may enable all the bus lines to be tested simultaneously instead of sequentially.

A "property" of the conductive interconnect may for example be the quality of a connection between the conductive interconnect and an electronic component, such as a passive component and/or an embedded component. Other examples are the quality of a connection between the conductive interconnect and a solder ball of a Ball Grid Array package, a solder joint, a silicon component pad and/or a via connection.

That the connection between the conductive sensing path and the conductive interconnect is "galvanically isolated" means that the conductive sensing path and the conductive interconnect are not in direct electrical contact.

The testing device described above can have a simple design and may be easy to use. It may provide relevant information about whether a conductive interconnect under test is defective and possibly also some information about the type of defect. Moreover, the testing device may help to improve end product quality by increasing fault coverage. The testing device is particularly suitable for testing High Density Interconnect circuits, the high wiring density of which may render physical probing, and also visual inspection, of interconnects difficult or impossible. Similar difficulties arise with circuits having Ball Grid Array packages and circuits having embedded components and solderless interconnects, for example with circuits manufactured using solderless Sequential Build Up technology. The testing devicemay facilitate testing interconnects in such circuits as well.

Many variants of the testing device are conceivable. For example, the testing circuit may have two or more conductive sensing paths. The testing device may comprise a dielectric layer covering the conductive sensing paths. Such a layer may help to protect the conductive sensing paths from damage, and it can enable the formation of broadside-coupled striplines together with the conductive sensing path and the conductive interconnect.

The signal generator can be a frequency generator configured to generate an input signal in the form of a frequency sweep and/or an input signal with a predetermined frequency. The predetermined frequency may be a resonance frequency of a system consisting of the conductive sensing path and a conductive interconnect free from defects. For example, the predetermined frequency may be the lowest resonance frequency of such a system. An often time-efficient way to determine the predetermined frequency is by means of computer simulation. The predetermined frequency may alternatively be determined through experiments.

In order to determine a property of the conductive interconnect, the processing circuitry may be configured to measure a frequency response, i.e. a frequency-dependent relation between the input signal and the output signal, such as a transfer function or a scattering parameter.

A testing device according to the description above may be included in a testing arrangement which also includes a conductive interconnect on a circuit board, for example a printed circuit board or a printed wiring board. In such a testing arrangement, the circuit board and the testing device are arranged so that the conductive sensing path is parallel displaced relative to the conductive interconnect, along a direction perpendicular to a parallel plane to the conductive interconnect, and so that the conductive sensing path forms a galvanically isolated connection with the conductive interconnect.

The testing arrangement may provide for similar or identical technical effects as the testing device included therein. Various alternative testing arrangements are conceivable. The testing arrangement may for example comprise one or more dielectric layers arranged between the conductive sensing path and the conductive interconnect. More specifically, the testing device may have a dielectric layer covering the conductive sensing path and/or the circuit board may have a dielectric layer covering the conductive interconnect.

According to a second aspect, a testing method for contactless testing of a conductive interconnect on a circuit board is provided. The testing method comprises a step of providing a conductive sensing path the extension of which corresponds to the extension of the conductive interconnect. The testing method also comprises a step of arranging the conductive sensing path parallel displaced relative to the conductive interconnect, along a direction perpendicular to a parallel plane to the conductive interconnect, so that the conductive sensing path forms a galvanically isolated connection with the conductive interconnect. Furthermore, the testing method comprises the steps of providing an input signal to the conductive sensing path and determining a property of the conductive interconnect based on an output signal.

The second aspect may provide for technical effects which are identical or similar to those of the first aspect. Many variants of the testing method are conceivable. For example, the input signal may be provided in the form of a frequency sweep or as a signal with a predetermined frequency. The testing method may include a step in which the predetermined frequency is determined through computer simulation or experiment. The testing method may comprise a step of measuring a frequency response.

### BRIEF DESCRIPTION OF THE DRAWINGS

The following drawings are included for exemplifying purposes.
Figure 1 illustrates a schematic view of a testing device.
Figure 2 illustrates a schematic view of an alternative testing device.
Figure 3 illustrates a schematic perspective view of a testing device and a circuit board with a conductive interconnect under test.
Figure 4 illustrates a schematic cross-sectional side view of a testing device and circuit board with a conductive interconnect under test.
Figure 5 shows a schematic electrical circuit diagram of a testing device and a circuit board with a conductive interconnect under test.
Figure 6 illustrates a schematic perspective view of a multilayered circuit board.

The figures are not drawn to scale, and similar or identical elements are labeled with the same reference numerals.

### DETAILED DESCRIPTION

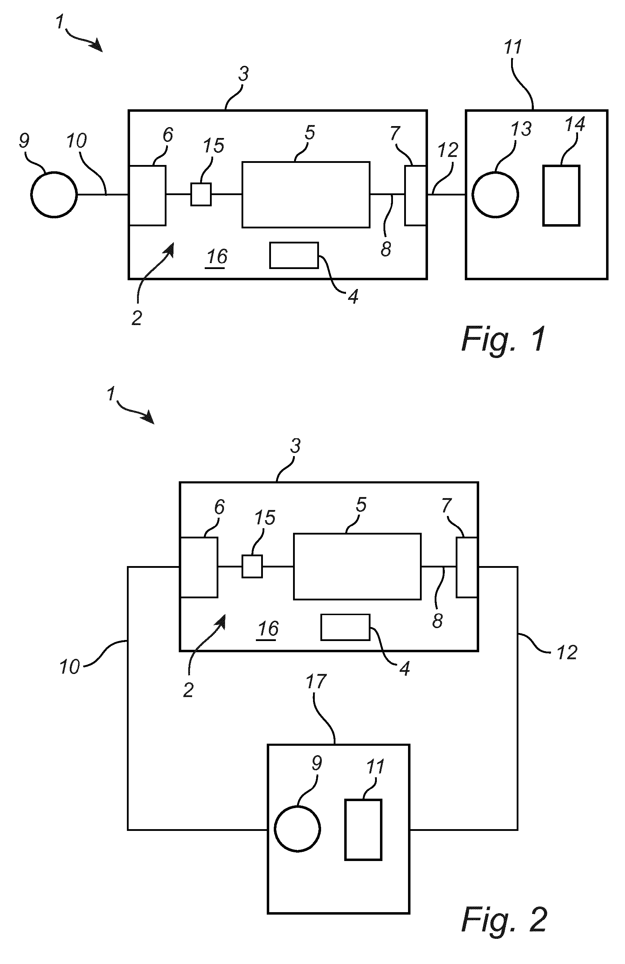

Figure 1 depicts a testing device 1 with a testing circuit 2 arranged on a support structure 3. The shape of the support structure 3 can be planar and rectangular. Typically, the support structure 3 is a board of a type that is used for printed circuit boards. The support structure 3 can have one or more through holes 4 for receiving protruding electronic components on a circuit board positioned next to the support structure 3.

The testing circuit 2 includes one or more conductive sensing paths 5 arranged on the support structure 3. The conductive sensing paths 5 can be formed by wires, such as metal wires. The conductive sensing paths 5 may be formed by a conductive material printed on the support structure 3 or by a conductive pattern etched on the support structure 3. Arranging the conductive sensing paths 5 on the support structure 3 is generally done using known techniques for producing printed circuit boards.

The extension of the conductive sensing paths 5 corresponds to the extension of the conductive interconnects which the testing device 1 is designed to test. Furthermore, the conductive sensing paths 5 are electrically connected to a first terminal 6 and a second terminal 7. The conductive sensing paths 5 may be electrically connected to the first 6 and second 7 terminals through connections 8 in the form of conductive paths, wires or cables. However, the conductive sensing paths 5 may be directly connected to the first 6 and second 7 terminals, without any connections 8 in between. The connections 8 may include one or more via connections, i.e. electrical connections between different layers of a circuit board.

The first terminal 6 is electrically connected to a signal generator 9, for example by means of a connection 10 in the form of a conductive path, wire or cable. The signal generator 9 is typically not arranged on the support structure 3, although it can be. The signal generator 9 can for example be a frequency generator such as a radio frequency signal generator or a microwave signal generator. The internal impedance of the signal generator 9 can be 50 Ω, or approximately 50 Ω. An internal impedance of 50 Ω is a common standard for radio frequency devices. The signal generator 9 is configured to generate an input signal Sᵢ to be transmitted from the first terminal 6 to the second terminal 7 via the conductive sensing paths 5. The input signal Sᵢ can be a time-varying electrical signal, such as a voltage waveform. The input signal Sᵢ can be discreet or continuous, for example sinusoidal. The frequency of the input signal Sᵢ may vary or be constant. The input signal Sᵢ may be a frequency sweep signal, i.e. a signal with a varying frequency and a fixed amplitude. The frequency of the input signal Sᵢ usually varies continuously during a frequency sweep. The input signal Sᵢ can have a constant amplitude or a varying amplitude. The input signal Sᵢ may be an amplitude sweep signal, i.e. a signal with a varying amplitude and a fixed frequency. The amplitude of the input signal Sᵢ usually varies continuously during an amplitude sweep.

The second terminal 7 is electrically connected to a processing circuitry 11, for example by means of a connection 12 in the form of a conductive path, wire or cable. The processing circuitry 11 is typically not arranged on the support structure 3, although it can be. The processing circuitry 11 may include various components such as an analog-to-digital converter 13 and/or a central processing unit 14. The input impedance of the processing circuitry 11 may equal the internal impedance of the signal generator 9. The input impedance of the processing circuitry 11 can be 50 Ω, or approximately 50 Ω.

The testing circuit 2 may also include a switch 15 for opening and closing the electrical connection between the first terminal 6 and individual conductive sensing path 5. The switch 15 can for example be a radio frequency switch or a demultiplexer.

The conductive sensing paths 5 and the side of the support structure 3 with the conductive sensing paths 5 can be covered by a dielectric layer 16, for example a polymer layer, an epoxy layer, an FR4 layer or a layer of a lacquer for electronics manufacturing. The thickness of the dielectric layer 16 can for example be approximately 50 µm or less.

Figure 2 shows a testing device 1 which is similar to the one in figure 1. However, the testing device in figure 2 has a network analyzer 17 connected to the first 6 and second 7 terminals by means of the connections 10 and 12. The signal generator 9 and the processing circuitry 11 are in this embodiment integrated with the network analyzer 17.

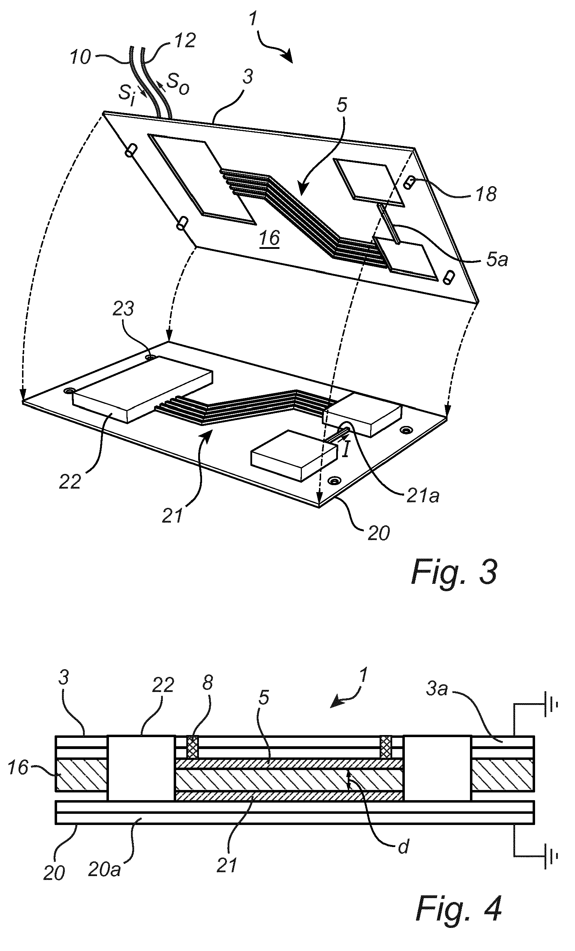

Figure 3 illustrates schematically a testing device 1 arranged to test one or more of the conductive interconnects 21 of a circuit board 20. The circuit board 20 can for example be a printed circuit board or a printed wiring board. The circuit board 20 can be a High Density Interconnect circuit board. A conductive interconnect 21 can for example be one of a conductive path, a parallel buse and a microstripline-based passive component. The various conductive interconnects 21 can be of different types. One or more electronic components 22 can be mounted on the circuit board 20, and they are connected via the conductive interconnects 21. Examples of such electronic components 22 are transistors, resistors, capacitors, inductors, transformers, Ball Grid Array packages, and silicon component pads. The electronic components 22 can be passive components and/or embedded components.

The circuit board 20 may have one or more connections 23 which are adapted to be connected to a ground potential and which are adapted to receive an elongated object, such as a small pin. Four such connections 23 are shown in figure 3. The connections 23 can be via connections.

The testing device 1 in figure 3 is similar to the ones in figure 1 and 2, although some of the elements of the testing device 1 that are shown in figures 1 and 2 are not shown in figure 3. For example, the first 6 and second 7 terminals, the connections 8 and the switch 15 are hidden from view in figure 2 as they are arranged on the side of the support structure 3 opposite the side with the conductive sensing paths 5. The positions and shapes of the through holes 4 in the support structure 3 are adapted to receive projecting electronic components 22 on the circuit board 20 so that the conductive sensing paths 5 and the conductive interconnects 21 can be arranged closer together than otherwise would have been possible. The testing device 1 can have one or more conductive pins 18 which are insertable into the connections 23. Four such pins 18 are shown in figure 3. The pins 18 and the connections 23 make it possible to connect the testing device 1 and the circuit board 20 to a common ground potential. Insertion of the pins 18 into the connections 23 may also help ensure proper alignment of the of the conductive sensing paths 5 relative to the conductive interconnects 21.

Figure 4 shows a schematic cross-sectional side view of a testing device 1 and circuit board 20 with a conductive interconnect 21 under test. The supporting structure 3 is shown having a conductive layer 3a arranged on the side opposite the side with the conductive sensing paths 5. The conductive layer 3a can for example be a metal foil, and it is connected to a ground potential. The circuit board 20 is shown having a similar conductive layer 20a connected to a ground potential. The conductive layers 3a and 20a are substantially coplanar and can be connected to the same ground potential.

The connections 8 as shown in figure 4 include via connections arranged by end portions of the conductive sensing path 5. These via connections pass through the support structure 3 and are electrically isolated from the conductive layer 3a.

The conductive sensing path 5 and the conductive interconnect 21 are arranged between the conductive layers 3a and 20a and separated by a distance d along a direction which is substantially perpendicular to the the conductive layers 3a and 20a. The distance d can be in the range from approximately 1 µm to approximately 100 µm, for example less than 50 µm, 25 µm or 10 µm. Typically, the smaller the distance d, the stronger the galvanically isolated connection between the conductive sensing paths 5 and the conductive interconnect 21. The dielectric layer 16 is arranged on the support structure 3 and in physical contact with the conductive sensing path 5 and the conductive interconnect 21. It should be noted that the dielectric layer 16 may be arranged on the circuit board 20 instead. A further alternative is that the support structure 3 as well as the circuit board 20 are provided with dielectric layers.

When looking at figure 4, it is clear that conductive sensing path 5 and the conductive interconnect 21 may form broadside-coupled striplines (conducting lines embedded in a dielectric between grounded planes) and may be analyzed using known techniques for such systems.

As is shown in figures 3 and 4, the support structure 3 is during testing positioned so that the side of the support structure 3 with the conductive sensing paths 5 faces and is coplanar with the side of the circuit board 20 with the conductive interconnects 21. The support structure 3 and the circuit board 20 are arranged so that at least one of the conductive sensing paths 5 is parallel displaced relative to a corresponding conductive interconnect of the conductive interconnects 21 along a direction perpendicular to a parallel plane to said conductive interconnect, whereby the at least one conductive sensing path 5 forms a galvanically isolated connection with said conductive interconnect. As is shown in figures 3 and 4, this arrangement may imply that the conductive sensing paths 5 and the conductive interconnects 21 are mirror images of each other with respect to a plane which is positioned between the support structure 3 and the circuit board 20 and which is parallel to the side of the support structure 3 with the conductive sensing paths 5 and the side of the circuit board 20 with the conductive interconnects 21. Stated in another way, the conductive sensing paths 5 can be positioned directly above the conductive interconnects 21.

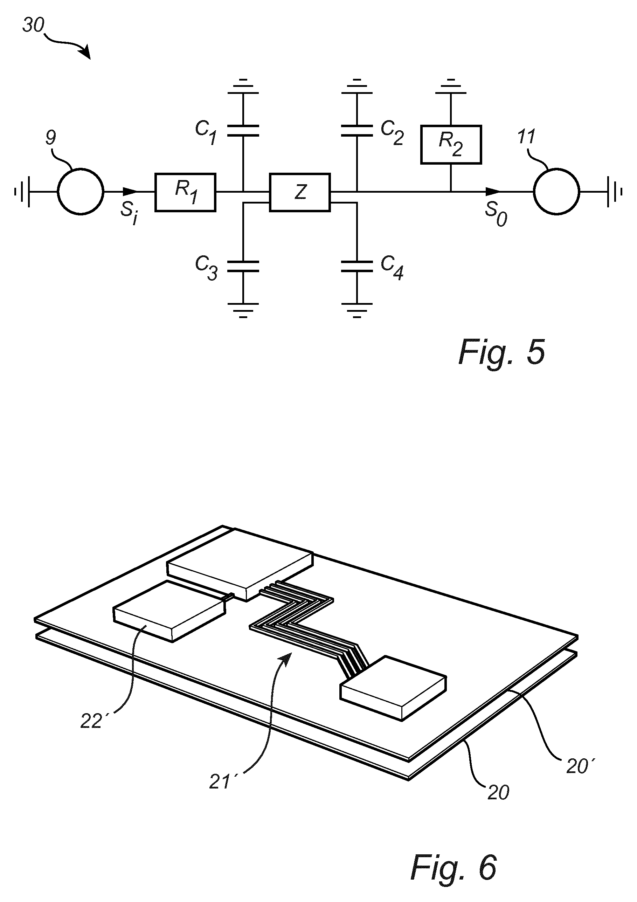

Figure 5 shows a schematic diagram of an example of an electrical circuit 30 formed by a testing device 1 and a circuit board 20 with a conductive interconnect under test such as shown in figures 3 and 4. The signal generator 9 has an internal impedance R₁ and is connected to a 4-port network which represents a conductive sensing path 5 and a corrresponding conductive interconnect 21 under test. The 4-port network has an impedance matrix Z. The capacitances C₁ and C₂ represent connections 8 of the testing circuit 2. The capacitances C₃ and C₄ represent the I/O capacitances of the electronic components 22 to which the conductive interconnect 21 is connected. R₂ represents the input impedance of the processing circuitry 11. R₁ and R₂ may be equal. For instance, R₁ and R₂ can both be 50 Ω.

The conductive interconnects 21 are typically tested for defects one at a time. In order to test a particular conductive interconnect 21 a an input signal Sᵢ is generated by the signal generator 9 at the first terminal 6. The signal generator 9 may generate an input signal Sᵢ with a predetermined frequency or an input signal Sᵢ in the form of a frequency sweep. An input signal Sᵢ with a predetermined frequency has a single frequency.

The predetermined frequency may be a resonance frequency of a system consisting of the conductive sensing path 5a and a conductive interconnect which is identical, or similar, to the one under test and which is free from defects. The lowest resonance frequency is usually of particular interest since, during testing, interference disturbances from other conductive interconnects than the one under test often increases with the frequency of the input signal Sᵢ. The resonance frequencies can for example be determined through experiments on a conductive interconnect free from defects. An alternative to experimental determination of the resonance frequencies are computer simulations, such as detailed three-dimensional electromagnetic simulations. The computer simulations can be based on a model for broadside-coupled striplines. A useful reference for constructing such a model is the paper "Coupled-strip-transmission-line filters and directional couplers" by E. Jones (Microwave Theory and Techniques, IRE Transactions on, vol. 4, no. 2, pp. 75-81, April 1956).

The input signal Sᵢ is transmitted to the conductive sensing path 5a which corresponds to the conductive interconnect 21 a under test. In order for the input signal Sᵢ to reach the conductive sensing path 5a, the switch 15 may have to be adjusted accordingly. The conductive sensing path 5a and the conductive interconnect 21 a are electromagnetically coupled, interacting through dual stripline crosstalk. The flow of the input signal Sᵢ through the conductive sensing path 5a induces a current I in the conductive interconnect 21 a. The input signal Sᵢ and the current I interact electromagnetically, something which affects the output signal Sₒ received at the second terminal 7 by the processing circuitry 11.

The processing circuitry 11 is configured to determine a property of the conductive interconnect 21 a based on the output signal Sₒ. The determination of a property of the conductive interconnect 21 a includes the measuring of the output signal Sₒ by the processing cicuitry 11. The processing circuitry 11 may be configured to measure the voltage level and/or the current level of the output signal So. The processing circuitry 11 may be configured to measure an impedance Z representing the interacting conductive sensing path 5a and the conductive interconnect 21 a. The processing circuitry 11 may be configured to measure a frequency response. An example of a frequency response of interest is the transmission coefficient S₁₂. If the internal impedance of the signal generator 9 and the input impedance of the processing circuitry 11 are both 50 Ω, the transmission coefficient S₁₂ equals two times a voltage V₂ of the output signal Sₒ divided by a voltage V₁ of the input signal Sᵢ, i.e. S₁₂ = 2×V₂/V₁. A particularly convenient way to measure the transmission coefficient S₁₂ is by means of a network analyzer 17.

The result of the measurement of the output signal Sₒ is compared with a performance standard, whereby it is possible to obtain information about a property of the conductive interconnect 21 a. The performance standard can be established from "testing" a conductive interconnect which is similar to the conductive interconnect 21 a under test and known to be free from defects. Alternatively, the performance standard can be established from computer simulations similar to those described above.

According to one example, the transmission coefficient S₁₂ resulting from an input signal Sᵢ with a predetermined frequency is measured and compared with a corresponding transmission coefficient S₁₂' representing the performance standard. The interconnect 21 a may be identified as defective if the transmission coefficients S₁₂ and S₁₂' differ by more than a threshold value. A suitable treshold value can for example be determined by studying the impact of manufacturing variations on the frequency response. One may wish to repeat this procedure for several different input signal frequencies as this may result in a more reliable determination of the property of the conductive interconnect. The different input signal frequencies may be resonance frequencies, or they may be centered around a resonance frequency.

According to another example, the the signal generator 9 generates a input signal Sᵢ in the form of a frequency sweep. The transmission coefficient S₁₂ is measured for a range of input signal frequencies in order to identify a resonance frequency, typically the lowest, of the system consisting of the conductive sensing path 5a and a conductive interconnect 21 a. The conductive interconnect 21 a may be diagnosed as defective if the identified resonance frequency differs by more than a threshold value from a frequency representing the performance standard. More than one resonance frequency, for example the lowest and the second to lowest, may of course be identified and compared with a corresponding performance standard. Such a procedure may result in a more reliable determination of the property of the conductive interconnect.

When testing a multilayered circuit board, the conductive interconnects of a layer are tested before the next layer is provided on top. Figure 6 shows a multilayered circuit board with a second layer 20' on top of a first layer 20. The conductive interconnects 21' and electronic components 22' of the second layer 20' are often different from those of the first layer 20. Thus, several testing devices, each of which is configured to test a respective layer, are typically used when testing a multilayered circuit board, and the testing is performed successively as layers are added during production. A multilayered circuit board like the one in figure 3 can for example be produced by means of solderless Sequential Build Up technology.

The person skilled in the art realizes that the present invention by no means is limited to the embodiments described above. On the contrary, many modifications and variations are possible within the scope of the appended claims. For example, determining a property of the conductive interconnect may comprise a step of providing an input signal with a predetermined frequency as well as a step of providing an input signal in the form of a frequency sweep. Such a procedure may enable the property of the conductive interconnect to be more accurately determined.

## Claims

1. A testing device (1) for contactless testing of a conductive interconnect (21) on a circuit board (20), the testing device (1) comprising:
a testing circuit (2) having a conductive sensing path (5) electrically connected to a first terminal (6) and to a second terminal (7), the extension of the conductive sensing path (5) corresponding to the extension of the conductive interconnect (21);
a signal generator (9) connected to said first terminal, and configured to generate an input signal (Sᵢ) to be transmitted from the first terminal (6) to the second terminal (7) via the conductive sensing path (5); and
a processing circuitry (11) configured to receive an output signal (So) at the second terminal (7),
the processing circuitry (11) being configured to determine a property of the conductive interconnect (21) based on the output signal (Sₒ) during testing when the conductive sensing path (5) is aligned with said conductive interconnect (21) and parallel displaced relative to the conductive interconnect (21) along a direction perpendicular to a planar extension of the circuit board (20), so that the conductive sensing path (5) forms a galvanically isolated electromagnetic connection with the conductive interconnect (21).

2. The testing device according to claim 1, wherein the testing device (1) comprises a dielectric layer (16) covering the conductive sensing path (5).

3. The testing device according to claim 1 or 2, wherein the testing circuit (2) has two or more conductive sensing paths (5).

4. The testing device according to any of the claims 1 to 3, wherein the signal generator (9) is a frequency generator.

5. The testing device according to claim 4, wherein the signal generator (9) is configured to generate an input signal (Sᵢ) in the form of a frequency sweep.

6. The testing device according to claim 4 or 5, wherein the signal generator (9) is configured to generate an input signal (Sᵢ) with a predetermined frequency.

7. The testing device according to claim 6, wherein the predetermined frequency is determined through computer simulation.

8. The testing device according to claim 6 or 7, wherein the predetermined frequency is determined through experiment.

9. A testing arrangement comprising:
a conductive interconnect (21) on a circuit board (20), and
a testing device (1) according to any of the preceding claims,
wherein the testing device (1) and the conductive interconnect (21) are arranged so that the conductive sensing path (5) is aligned with said conductive interconnect (21) and parallel displaced relative to the conductive interconnect (21) along a direction perpendicular to a planar extension of the circuit board (20), so that the conductive sensing path (5) forms a galvanically isolated electromagnetic connection with the conductive interconnect (21).

10. The testing arrangement according to claim 9, further comprising one or more dielectric layers (16) arranged between the conductive sensing path (5) and the conductive interconnect (21).

11. A testing method for contactless testing of a conductive interconnect (21) on a circuit board (20), the testing method comprising the steps of:
providing a conductive sensing path (5) the extension of which corresponds to the extension of the conductive interconnect (21);
arranging the conductive sensing path (5) so that the conductive sensing path (5) is aligned with said conductive interconnect (21) and parallel displaced relative to the conductive interconnect (21) along a direction perpendicular to a planar extension of the circuit board (20), so that the conductive sensing path (5) forms a galvanically isolated electromagnetic connection with the conductive interconnect (21);
providing an input signal (Sᵢ) to the conductive sensing path (5); and
determining a property of the conductive interconnect (21) based on an output signal (Sₒ).

12. The testing method according to claim 11, wherein the input signal (Sᵢ) is provided in the form of a frequency sweep.

13. The testing method according to claim 11 or 12, wherein the input signal (Sᵢ) has a predetermined frequency.

14. The testing method according to claim 13, further comprising a step of determining the predetermined frequency through computer simulation.

15. The testing method according to claim 13 or 14, further comprising a step of determining the predetermined frequency through experiment.

## Patentansprüche

1. Prüfvorrichtung (1) zur berührungslosen Prüfung einer leitfähigen Leiterbahn (21) auf einer Leiterplatte (20), wobei die Prüfvorrichtung (1) Folgendes umfasst:
eine Prüfschaltung (2), die einen leitfähigen Erfassungspfad (5) aufweist, der mit einem ersten Anschluss (6) und einem zweiten Anschluss (7) elektrisch verbunden ist, wobei die Ausdehnung des leitfähigen Erfassungspfades (5) der Ausdehnung der leitfähigen Leiterbahn (21) entspricht;
einen Signalgenerator (9), der mit dem ersten Anschluss verbunden ist, und der zur Erzeugung eines Eingangssignals (Sᵢ), das über den leitfähigen Erfassungspfad (5) von dem ersten Anschluss (6) zum zweiten Anschluss (7) übertragen wird, konfiguriert ist; und
eine Verarbeitungsschaltung (11), die zum Empfang eines Ausgangssignals (Sₒ) am zweiten Anschluss (7) konfiguriert ist,
wobei die Verarbeitungsschaltung (11) konfiguriert ist, um eine Eigenschaft der leitfähigen Leiterbahn (21) aufgrund des Ausgangssignals (Sₒ) während der Prüfung zu ermitteln, wenn der leitfähige Erfassungspfad (5) mit der leitfähigen Leiterbahn (21) ausgerichtet ist und parallel zu der leitfähigen Leiterbahn (21) entlang einer Richtung senkrecht zu einer flächigen Ausdehnung der Leiterplatte (20) verschoben ist, sodass der leitfähige Erfassungspfad (5) eine galvanisch nicht isolierte elektromagnetische Leiterbahn mit der leitfähigen Leiterbahn (21) bildet.

2. Prüfvorrichtung nach Anspruch 1, wobei die Prüfvorrichtung (1) eine dielektrische Schicht (16) umfasst, welche den leitfähigen Erfassungspfad (5) bedeckt.

3. Prüfvorrichtung nach Anspruch 1 oder 2, wobei die Prüfvorrichtung (2) zwei oder mehr leitfähige Erfassungspfade (5) aufweist.

4. Prüfvorrichtung nach einem der Ansprüche 1 bis 3, wobei der Signalgenerator (9) ein Frequenzgenerator ist.

5. Prüfvorrichtung nach Anspruch 4, wobei der Signalgenerator (9) zur Erzeugung eines Eingangssignals (Sᵢ) in Form eines Frequenzsweeps konfiguriert ist.

6. Prüfvorrichtung nach Anspruch 4 oder 5, wobei der Signalgenerator (9) zur Erzeugung eines Eingangssignals (Sᵢ) mit einer vorgegebenen Frequenz konfiguriert ist.

7. Prüfvorrichtung nach Anspruch 6, wobei die vorgegebene Frequenz durch Computersimulation ermittelt wird.

8. Prüfvorrichtung nach Anspruch 6 oder 7, wobei die vorgegebene Frequenz experimentell ermittelt wird.

9. Prüfanordnung, umfassend:
eine leitfähige Leiterbahn (21) auf einer Leiterplatte (20) und
eine Prüfvorrichtung (1) nach einem der vorhergehenden Ansprüche,
wobei die Prüfvorrichtung (1) und die leitfähige Leiterbahn (21) so angeordnet sind, dass der leitfähige Erfassungspfad (5) mit der leitfähigen Leiterbahn (21) ausgerichtet ist und parallel zu der leitfähigen Leiterbahn (21) entlang einer Richtung senkrecht zu einer flächigen Ausdehnung der Leiterplatte (20) verschoben ist, sodass der leitfähige Erfassungspfad (5) eine galvanisch nicht isolierte elektromagnetische Leiterbahn mit der leitfähigen Leiterbahn (21) bildet.

10. Prüfanordnung nach Anspruch 9, ferner umfassend eine oder mehr dielektrische Schichten (16), die zwischen dem leitfähigen Erfassungspfad (5) und der leitfähigen Leiterbahn (21) angeordnet sind.

11. Prüfverfahren zur berührungslosen Prüfung einer leitfähigen Leiterbahn (21) auf einer Leiterplatte (20), wobei das Prüfverfahren folgende Schritte umfasst:
Bereitstellen eines leitfähigen Erfassungspfades (5), dessen Ausdehnung der Ausdehnung der leitfähigen Leiterbahn (21) entspricht;
Anordnen des leitfähigen Erfassungspfads (5), so dass der leitfähige Erfassungspfad (5) mit der leitfähigen Leiterbahn (21) ausgerichtet ist und parallel zu der leitfähigen Leiterbahn (21) entlang einer Richtung senkrecht zu einer flächigen Ausdehnung der Leiterplatte (20) verschoben ist, sodass der leitfähige Erfassungspfad (5) eine galvanisch nicht isolierte elektromagnetische Leiterbahn mit der leitfähigen Leiterbahn (21) bildet;
Bereitstellen eines Eingangssignals (Sᵢ) an den leitfähigen Erfassungspfad (5); und
Ermitteln einer Eigenschaft der leitfähigen Leiterbahn (21) aufgrund des Ausgangssignals (Sₒ).

12. Prüfverfahren nach Anspruch 11, wobei das Eingangssignal (Sᵢ) in Form eines Frequenzsweeps bereitgestellt wird.

13. Prüfverfahren nach Anspruch 11 oder 12, wobei das Eingangssignal (Sᵢ) eine vorgegebene Frequenz aufweist.

14. Prüfverfahren nach Anspruch 13, ferner umfassend einen Schritt der Ermittlung der vorgegebenen Frequenz durch Computersimulation.

15. Prüfverfahren nach Anspruch 13 oder 14, Ferner umfassend einen Schritt der experimentellen Ermittlung der vorgegebenen Frequenz.

## Revendications

1. Dispositif de test (1) pour le test de sans contact d'une interconnexion conductrice (21) sur une carte de circuit imprimé (20), le dispositif de test (1) comprenant :
un circuit de test (2) ayant une piste de détection conductrice (5) connectée électriquement à une première borne (6) et à une seconde borne (7), l'extension de la piste de détection conductrice (5) correspondant à l'extension de l'interconnexion conductrice (21) ;
un générateur de signaux (9) connecté à ladite première borne et configuré pour générer un signal d'entrée (Sᵢ) à transmettre de la première borne (6) à la seconde borne (7) via la piste de détection conductrice (5) ; et
un circuit de traitement (11) configuré pour recevoir un signal de sortie (Sₒ) au niveau de la seconde borne (7),
le circuit de traitement (11) étant configuré pour déterminer une propriété de l'interconnexion conductrice (21) sur la base du signal de sortie (Sₒ) pendant le test lorsque la piste de détection conductrice (5) est alignée avec ladite interconnexion conductrice (21) et déplacée parallèlement par rapport à l'interconnexion conductrice (21) le long d'une direction perpendiculaire à une extension planaire de la carte de circuit imprimé (20), de sorte que la piste de détection conductrice (5) forme une connexion électromagnétique galvaniquement isolée avec l'interconnexion conductrice (21).

2. Dispositif de test selon la revendication 1, dans lequel le dispositif de test (1) comprend une couche diélectrique (16) couvrant la piste de détection conductrice (5).

3. Dispositif de test selon la revendication 1 ou 2, dans lequel le circuit de test (2) possède deux ou plus pistes de détection conductrices (5).

4. Dispositif de test selon une quelconque des revendications 1 à 3, dans lequel le générateur de signaux (9) est un générateur de fréquence.

5. Dispositif de test selon la revendication 4, dans lequel le générateur de signaux (9) est configuré pour générer un signal d'entrée (Sᵢ) sous la forme d'un balayage de fréquence.

6. Dispositif de test selon la revendication 4 ou 5, dans lequel le générateur de signaux (9) est configuré pour générer un signal d'entrée (Sᵢ) avec une fréquence prédéterminée.

7. Dispositif de test selon la revendication 6, dans lequel la fréquence prédéterminée est déterminée par simulation informatique.

8. Dispositif de test selon la revendication 6 ou 7, dans lequel la fréquence prédéterminée est déterminée par des expériences.

9. Agencement de test comprenant :
une interconnexion conductrice (21) sur une carte de circuit imprimé (20) ; et
un dispositif de test (1) selon une quelconque des revendications précédentes,
dans lequel le dispositif de test (1) et l'interconnexion conductrice (21) sont agencées de sorte que la piste de détection conductrice (5) soit alignée avec ladite interconnexion conductrice (21) et déplacée parallèlement par rapport à l'interconnexion conductrice (21) le long d'une direction perpendiculaire à une extension planaire de la carte de circuit imprimé (20), de sorte que la piste de détection conductrice (5) forme une connexion électromagnétique galvaniquement isolée avec l'interconnexion conductrice (21).

10. Agencement de test selon la revendication 9, comprenant en outre une ou plusieurs couches diélectriques (16) agencées entre la piste de détection conductrice (5) et l'interconnexion conductrice (21).

11. Procédé de test pour le test sans contact d'une interconnexion conductrice (21) sur une carte de circuit imprimé (20), le procédé de test comprenant les étapes suivantes consistant à :
fournir une piste de détection conductrice (5) dont l'extension correspond à l'extension de l'interconnexion conductrice (21) ;
agencer la piste de détection conductrice (5) de sorte que la piste de détection conductrice (5) soit alignée avec ladite interconnexion conductrice (21) et déplacée parallèlement par rapport à l'interconnexion conductrice (21) le long d'une direction perpendiculaire à une extension planaire de la carte de circuit imprimé (20), de sorte que la piste de détection conductrice (5) forme une connexion électromagnétique galvaniquement isolée avec l'interconnexion conductrice (21) ;
fournir un signal d'entrée (Sᵢ) à la piste de détection conductrice (5) ; et
déterminer une propriété de l'interconnexion conductrice (21) sur la base d'un signal de sortie (Sₒ).

12. Procédé de test selon la revendication 11, dans lequel le signal d'entrée (Sᵢ) est fourni sous la forme d'un balayage de fréquence.

13. Procédé de test selon la revendication 11 ou 12, dans lequel le signal d'entrée (Sᵢ) a une fréquence prédéterminée.

14. Procédé de test selon la revendication 13, comprenant en outre une étape de détermination de la fréquence prédéterminée par simulation informatique.

15. Procédé de test selon la revendication 13 ou 14, comprenant en outre une étape de détermination de la fréquence prédéterminée par des expériences.
